# EUROPÄISCHE PATENTSCHRIFT

(11) **EP 0 989 200 B1**
(45) Veröffentlichungstag und Bekanntmachung des Hinweises auf die Patenterteilung: **18.06.2003**
(21) Anmeldenummer: 99117392.3
(22) Anmeldetag: 03.09.1999
(51) Int. Cl.: C23C 14/24

(54) **Bedampfungsvorrichtung**
Evaporation device
Dispositif d'évaporation

(30) Priorität: 24.09.1998 DE 19843818
(43) Veröffentlichungstag der Anmeldung: 29.03.2000
(73) Patentinhaber: Applied Films GmbH & Co. KG, 63755 Alzenau (DE)
(72) Erfinder: Klemm, Günter, 63667 Nidda (DE); Neudert, Hans, 63579 Freigericht (DE); Achtner, Wolfgang, 63477 Maintal 1 (DE)
(74) Vertreter: Schlagwein, Udo, Dipl.-Ing.

(56) Entgegenhaltungen:
- EP-A- 0 337 369
- CH-A- 491 208
- DE-C- 868 091
- GB-A- 683 808
- US-A- 3 661 117
- US-A- 3 690 638
- US-A- 3 971 334

## Beschreibung

Die Erfindung betrifft eine Bedampfungsvorrichtung für Vakuum-Bedampfungsanlagen, welche einen mit einem elektrischen Heizer beheizten Verdampfer mit einem Tiegel zum Verdampfen von zugeführtem Metall und einen Düsenkörper mit einem Düsenspalt zum Austritt des erzeugten Metalldampfes aufweist, wobei der Düsenkörper als Hohlkörper ausgebildet ist und der Verdampfer ein an diesen Düsenkörper angeschlossenes, den Tiegel bildendes Verdampfergehäuse hat.

Eine Bedampfungsvorrichtung der vorstehenden Art ist in der US-A- 3,971,334 beschrieben. Das Verdampfergehäuse ist nach oben hin durch den Düsenkörper abgedeckt, welcher den Düsenspalt aufweist, durch den der Dampf zu der zu beschichtenden Folie gelangt. Der Düsenspalt muss so lang sein, wie die zu beschichtende Folie breit ist, weil die Folie zum Beschichten über diesen Düsenspalt geführt wird. Deshalb muss das Verdampfergehäuse entsprechend breit und damit großvolumig sein.

Solche großvolumigen Bedampfungsvorrichtungen führen dazu, dass ihr Aufheizen länger dauert als die Zeit zum Erzeugen des erforderlichen Vakuums in der Beschichtungsanlage. Deshalb muss man die Bedampfungsvorrichtung zunächst durch eine Blende verschließen und aufheizen, bevor das Bedampfen der Folie beginnen kann. Bei hohen Verdampfungsraten schlägt sich auf der Blende so viel Metall nieder, dass es von ihr abfallen und den Düsenspalt ganz oder in Teilbereichen verschließen kann. Ein weiterer Nachteil großvolumiger Bedampfungsvorrichtungen liegt darin, dass die Regelung der Verdampfungsrate sehr träge arbeitet, was an der großen Masse solcher Bedampfungsvorrichtungen und der großen Masse des in ihr vorhandenen, zu verdampfenden Metalls und daran liegt, dass die Temperatur in der Bedampfungsvorrichtung nur indirekt an der Außenwand des Heizrohres gemessen werden kann. Problematisch ist bei solchen Bedampfungsvorrichtungen zusätzlich, dass sich aufgrund von Verschleiß kurze Wartungszyklen ergeben und Isolationsfehler oder zündendes Plasma auftreten. Außerdem ist das Einschmelzen von einigen Metallen, z.B. von Zink, mit dem dabei notwendigen Entfernen der Oxidhaut und das Hantieren mit flüssigem Metall gefährlich und zeitaufwendig. Vorteilhaft ist allerdings, dass das Verdampfergehäuse zugleich den Tiegel für das zu verdampfende Metall bildet. Dies ermöglicht es, die Temperatur des flüssigen Metalls direkt am Verdampfergehäuse zu messen, so dass Veränderungen rasch feststellbar sind, was wiederum eine Steuerbarkeit und gute Regelbarkeit begünstigt.

Aus DE 868 091C ist eine Bedampfungsanlage bekannt, bei der in einem Verdampfergehäuse ein Tiegel untergebracht ist. Das Verdampfergehäuse steht über ein Rohr mit der Stirnseite eines zylindrischen Düsenkörpers in Verbindung. Der Düsenkörper weist einen sich in Längsrichtung des Düsenkörpers erstreckenden Düsenspalt auf. Der Nachteil dieser Anordnung ist, dass der Dampf ungleichmäßig aus dem Düsenspalt austritt, da das eine Ende des Düsenspaltes dem Rohreintritt in den Düsenkörper näher liegt als das andere.

Der Erfindung liegt das Problem zugrunde, eine Bedampfungsvorrichtung der eingangs genannten Art so auszubilden, dass ihre Verdampfungsrate möglichst rasch veränderbar ist und die zu möglichst geringen Verschmutzungen durch das verdampfte Metall führt, so dass möglichst lange Prozesszeiten ohne Stillstand der Anlage möglich werden, und dass der Dampf möglichst gleichmäßig aus dem Düsenspalt austritt.

Dieses Problem wird erfindungsgemäß dadurch gelöst, dass der Verdampfer mit seinem Verdampfergehäuse mit einem Teilbereich der Mantelfläche des Düsenkörpers verbunden ist, dass der Düsenkörper durch eine Trennwand in eine den Düsenspalt aufweisende Auslasskammer und eine mit dem Verdampfer verbundene Einlasskammer unterteilt ist und dass die Trennwand mehrere, mit zunehmendem Abstand von dem Verdampfergehäuse im Querschnitt zunehmende Dampfdurchlässe aufweist.

Dank der Erfindung kann der Verdampfer gegenüber dem Düsenkörper sehr kleinvolumig ausgebildet werden, so dass er nur eine geringe Metallmenge als Metallbad enthalten muss und deshalb seine Verdampfungsrate gut regelbar und rasch veränderbar ist. Die Gleichmäßigkeit des Dampfaustrittes aus dem Düsenspalt ist aber nicht beeinträchtigt, da wegen der Trennwand im Düsenkörper der Dampf sich zunächst in der Einlasskammer relativ gleichmäßig verteilen kann, bevor er durch die Durchlässe in die Auslasskammer tritt. Bei einem im Verhältnis zum Verdampfergehäuse sehr breiten Düsenkörper werden die Dampfdurchlässe mit zunehmendem Abstand vom Verdampfergehäuse im Querschnitt größer, so dass eine geringe Dichte in den vom Verdampfergehäuse entfernten Bereichen der Einlasskammer durch eine größere Übertrittswahrscheinlichkeit in die Auslasskammer kompensiert wird. Dort liegt damit eine gleichmäßige Dichte vor, so dass auch der Dampfaustritt gleichmäßig erfolgt.

Die Trennwand ist besonders einfach ausgebildet und lässt sich unterschiedlichen Erfordernissen sehr einfach anpassen, wenn die Dampfdurchlässe an der unteren Seite der Trennwand in Form von zur Unterseite hin offenen Ausnehmungen vorgesehen sind und wenn der Querschnitt dieser Dampfdurchlässe durch eine unterschiedliche Höhe der Dampfdurchlässe unterschiedlich ist.

Die Bedampfungsvorrichtung ist konstruktiv besonders einfach ausgebildet und für kleinere Verdampfungsraten völlig ausreichend zu bemessen, wenn gemäß einer vorteilhaften Weiterbildung der Erfindung der Düsenkörper als liegend angeordneter Zylinder ausgebildet und der Verdampfer mit seinem Verdampfergehäuse mit einem Teilbereich der Mantelfläche des Düsenkörpers verbunden ist.

Durch das Zuführen des zu schmelzenden und zu verdampfenden Metalles kann es zu einem Verspritzen flüssigen Metalls kommen. Solche Spritzer können nicht auf das zu bedampfende Substrat gelangen, wenn gemäß einer anderen Weiterbildung der Erfindung das Verdampfergehäuse in eine Chargierkammer und eine Verdampferkammer unterteilt ist und die Chargierkammer und die Verdampferkammer unterhalb des Flüssigkeitsspiegels des geschmolzenen Metallbades eine Flüssigkeitsverbindung haben.

Die Beheizung des Verdampfers ist optimal gestaltet, wenn das Verdampfergehäuse einen als Stahlrohr ausgebildeten Boden hat und wenn durch dieses Stahlrohr mit Abstand zu seiner Innenwandung ein Heizstab aus elektrisch leitender Keramik führt. Eine solche Heizung wirkt wie vergleichbare Heizungen durch Strahlung. Zusätzlich kommt es jedoch durch den geringen Querschnitt des Stahlrohres rasch zu einer magnetischen Sättigung des Stahlrohres, dadurch zu hohen elektrischen Verlusten und deshalb zu einer starken Erwärmung des Stahlrohres. Die erfindungsgemäße Heizung wirkt deshalb sowohl als Strahlungs- als auch als Induktionsheizung.

Zur Ausbildung der Heizung kann man auf für Verdampfungsschiffchen gebräuchliche und deshalb relativ kostengünstig erhältliche Bauteile zurückgreifen, wenn das Stahlrohr rechteckigen Querschnitt hat und der Heizstab ein übliches Verdampferschiffchen ist.

Wenn zum Abschluss des Bedampfungsvorganges kein Material mehr dem Verdampfer zugeführt werden muss oder wenn während des Prozesses neues Material in Form von Draht einzubringen ist, kann man einen Austritt von Dampf durch die zum Zuführen des Metalls erforderliche Öffnung im Verdampfer dadurch verhindern, dass zum Zuführen des zu verdampfenden Metalles in Form von Draht im Verdampfergehäuse ein Zuführrohr angeordnet ist und wenn das Zuführrohr einen bei nicht eingeführtem, drahtförmigem Metall das Innere des Verdampfergehäuses nach außen abdichtenden Verschluss hat.

Der Verschluss ist besonders einfach gestaltet, wenn er als eine zum Inneren des Verdampfergehäuses hin öffnende Klappe ausgebildet ist.

Bei größeren Beschichtungsanlagen sind die erforderlichen Bedampfungsvorrichtungen so groß, dass die Zeit zum Aufheizen der Bedampfungsvorrichtung wesentlich länger ist als die Abpumpzeit der gesamten Beschichtungsanlage. Die Bedampfungsvorrichtung kann in solchen Fällen schon unter Normaldruck beheizt werden, wenn gemäß einer Weiterbildung der Erfindung in die Verbindung zwischen dem Verdampfer und dem Düsenkörper eine Absperrvorrichtung angeordnet ist.

Beim Beheizen der Bedampfungsvorrichtung unter Normaldruck kann das Eindringen von Luft aufgrund von Leckagen in die Bedampfungsvorrichtung auf einfache Weise dadurch verhindert werden, dass der Verdampfer einen Inertgasanschluss hat. Hierdurch wird es möglich, dass Innere des Verdampfers vor dem Verbinden mit der Beschichtungsanlage unter Überdruck zu halten, so dass auch bei geringen Leckagen kein mit dem zu verdampfenden Metall reagierender Sauerstoff in den Verdampfer gelangen kann.

Für höhere Bedampfungsraten hat sich eine konstruktive Ausführungsform als vorteilhaft erwiesen, bei der das Verdampfergehäuse an einer Stirnseite des Düsenkörpers angeschlossen ist. Bei einer solchen Ausführungsform bereitet auch die Anordnung eines größeren Verdampfers eine Platzprobleme.

Ein gleichmäßiger Dampfaustritt über die gesamte Länge des Düsenspaltes lässt sich auf einfache Weise dadurch erreichen, dass das Verdampfergehäuse an demjenigen Bereich der Stirnwand des Düsenkörpers angeschlossen ist, welcher durch die Trennwand die Einlasskammer bildet.

Zur weiteren Vereinfachung des konstruktiven Aufbaus der Bedampfungsvorrichtung trägt es bei, wenn das Verdampfergehäuse zylindrisch und der Düsenkörper außermittig an der oberen Seite einer Stirnwand des Verdampfergehäuses angeschlossen ist.

Das Trennen des Verdampfergehäuses von dem Düsenkörper kann mit geringem Aufwand erfolgen, wenn gemäß einer anderen Weiterbildung der Erfindung der Verschluss zwischen dem Verdampfergehäuse und dem Düsenkörper durch einen Drehschieber im Anschluss des Düsenkörpers am Verdampfergehäuse gebildet ist.

Bei einem zylindrischen Verdampfergehäuse kann die Beheizung konstruktiv einfach dadurch erfolgen, dass an beiden Stirnseiten des Verdampfergehäuses zwei über das Verdampfergehäuse greifende Flanschplatten als Stromzuführung angeordnet sind, wobei die Flanschplatten der einen Stirnseite mit der Masse und die anderen Flanschplatten mit einer Spannungsversorgung verbunden sind, und dass zwischen den Flanschplatten der beiden Stirnseiten außenseitig entlang des Verdampfergehäuses Heizdrähte geführt sind.

Da die Bedampfungsvorrichtung während des Betriebs der Beschichtungsanlage unter Vakuum arbeitet, können die Heizdrähte nur Strahlungswärme zum Verdampfergehäuse hin übertragen. Die zur entgegengesetzten Seite hin abgestrahlte Wärme wird zum Verdampfergehäuse hin reflektiert, wenn die Heizdrähte von einem koaxial zu dem Verdampfergehäuse angeordneten Blechmantel umgeben sind.

Eine besonders hohe Heizleistung lässt sich mit geringem Aufwand erreichen, wenn die Heizdrähte gewendelt ausgebildet und jeweils in einem zum Verdampfergehäuse hin mit geringerem Querschnitt als es dem Durchmesser der Wendeln des Heizdrahtes entspricht offenen Isolierkörper angeordnet sind.

Die Erfindung lässt verschiedene Ausführungsformen zu. Mehrere davon sind in der Zeichnung schematisch dargestellt und werden nachfolgend beschrieben. Die Zeichnung zeigt in
- Fig.1: eine perspektivische Ansicht einer ersten Ausführungsform einer Bedampfungsvorrichtung nach der Erfindung,
- Fig.2: einen Schnitt durch einen unteren Bereich einer weiteren Ausführungsform der Bedampfungsvorrichtung,
- Fig.3: eine perspektivische Darstellung einer dritten Ausführungsform der Bedampfungsvorrichtung,
- Fig.4: einen Querschnitt durch die Bedampfungsvorrichtung nach Figur 3.

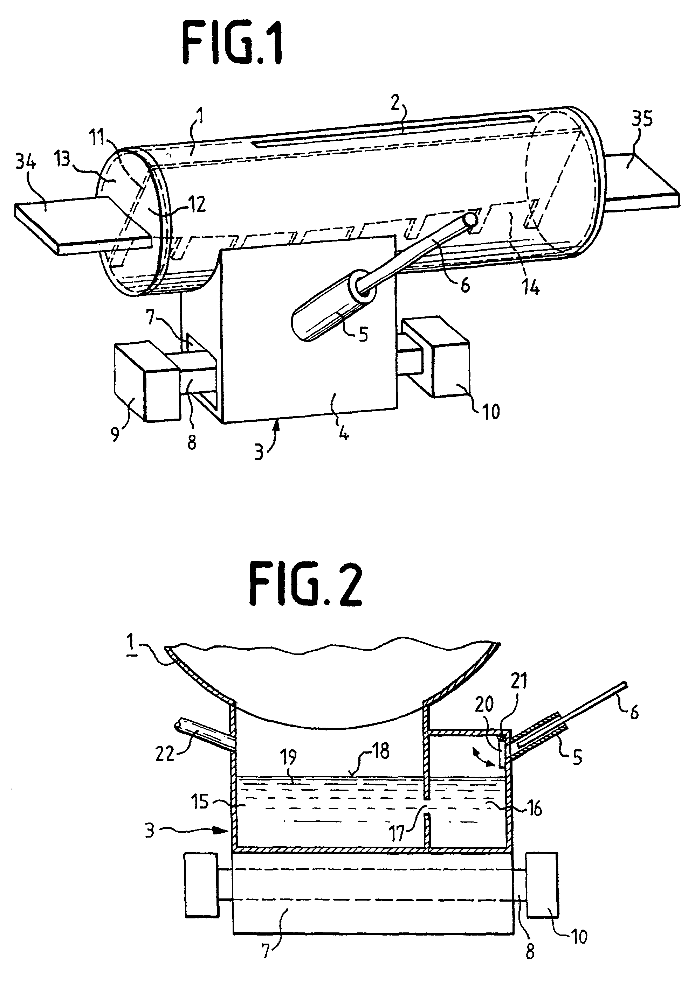

Die in Figur 1 als Ganzes gezeigte Bedampfungsvorrichtung, welche insbesondere zum Verdampfen von Zink in einer Folienbeschichtungsanlage bestimmt ist, hat einen rohrförmigen Düsenkörper 1 mit einem in seiner Mantelfläche längsverlaufenden Düsenspalt 2, aus welchem bei Betrieb der Anlage der für die Beschichtung einer Folie erforderliche Dampf austritt. An der Unterseite des Düsenkörpers 1 ist ein Verdampfer 3 mit einem Verdampfergehäuse 4 befestigt. Das Verdampfergehäuse 4 hat ein schräg angeordnetes Zuführrohr 5, durch welches im Verdampfer 3 zu schmelzendes Metall in Form von Draht 6 eingebracht werden kann. Zur Beheizung ist der Boden des Verdampfergehäuses 4 als im Querschnitt rechteckiges Stahlrohr 7 ausgebildet, durch welches ein Heizstab 8 aus elektrisch leitender Keramik hindurchgeführt ist. Zum Beheizen des Verdampfers 3 fließt elektrische Energie durch den Heizstab 8 von einem Stromanschluss 9 zu einem Stromanschluss 10 am anderen Ende des Heizstabes 8. Bei dem Heizstab 8 kann es sich um ein übliches Verdampferschiffchen handeln.

Der Düsenkörper 1 ist durch eine schräg angeordnete, gestrichelt dargestellte Trennwand 11 in eine Einlasskammer 12 und eine Auslasskammer 13 unterteilt. Dabei ist die Trennwand 11 so ausgerichtet, dass der Verdampfer 3 ausschließlich mit der Einlasskammer 12 und der Düsenspalt 2 ausschließlich mit der Auslasskammer 13 Verbindung hat. In der Unterseite der Trennwand 11 sind nebeneinander mehrere Dampfdurchlässe 14 vorgesehen, durch welche der aus dem Verdampfer 3 in die Einlasskammer 12 gelangende Dampf in die Auslasskammer 13 zu strömen vermag. Um eine gleichmäßige Dampfverteilung zu erreichen, ist der Querschnitt dieser Dampfdurchlässe 14 durch eine unterschiedliche Höhe umso größer, je mehr Abstand diese Dampfdurchlässe 14 vom Verdampfer 3 haben.

Um zu verhindern, dass in den Düsenkörper 1 gelangender Dampf dort kondensiert, hat der Düsenkörper 1 an beiden Enden jeweils einen elektrischen Anschluss 34, 35. Dadurch kann man durch Hochstrom, welcher durch den Düsenkörper 1 fließt, dafür sorgen, dass dieser stets eine Temperatur hat, die etwa 100°C über der Schmelztemperatur des Verdampfungsgutes liegt.

Bei der Ausführungsform nach Figur 2 ist das Verdampfergehäuse 4 in eine Verdampferkammer 15 und eine Chargierkammer 16 unterteilt. Nur die Verdampferkammer 15 hat Verbindung mit dem Düsenkörper 1. Eine Flüssigkeitsverbindung 17 verbindet die Chargierkammer 16 mit der Verdampferkammer 15. Diese Flüssigkeitsverbindung 17 ist so niedrig angeordnet, dass sie sich stets unterhalb des Flüssigkeitsspiegels 18 eines in dem Verdampfergehäuse 4 vorhandenen Metallbades 19 befindet. Das Zuführrohr 5 führt bei dieser Ausführungsform in das Innere der Chargierkammer 16, so dass der zugeführte Draht 6 in der Chargierkammer 16 eingeschmolzen wird. Diese Schmelze gelangt über die Flüssigkeitsverbindung 17 in die Verdampferkammer 15, wo durch die Wirkung des Heizstabes 8, der bei dieser Ausführungsform quer zum Düsenkörper 1 ausgerichtet ist, das Metall verdampft und in den Düsenkörper 1 gelangt. Dort wo das Zuführrohr 5 in die Chargierkammer 16 mündet, ist in der Chargierkammer 16 ein durch eine um ein Scharnier 21 schwenkbare Klappe gebildeter Verschluss 20 vorgesehen. Dieser Verschluss 20 ist in Schließrichtung vorgespannt, so dass sich das Zuführrohr 5 zwangsläufig verschließt, wenn man den Draht 6 herauszieht. Dadurch wird das Eindringen von Luft in die Chargierkammer 16 verhindert. Ein Inertgasanschluss 22 am Gehäuse 4 des Verdampfers 3 ermöglicht die Zufuhr von Inertgas, wenn der Verdampfer 3 nicht unter Vakuum steht und abgetrennt von dem Düsenkörper 1 aufgeheizt wird.

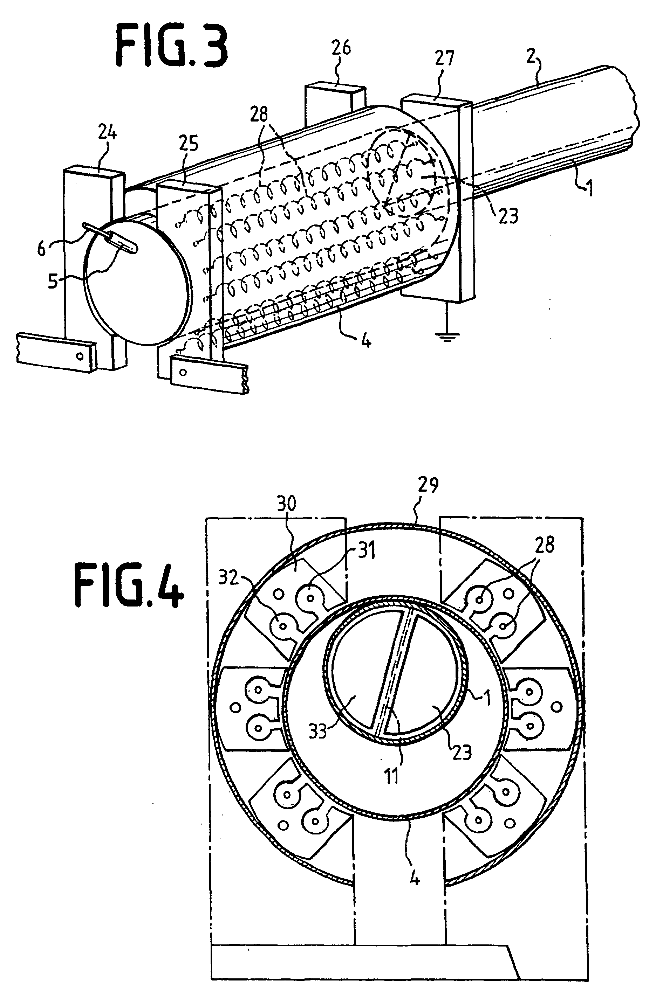

Bei der Ausführungsform nach Figur 3 ist das Verdampfergehäuse 4 zylindrisch ausgebildet und stirnseitig vor dem Düsenkörper 1 angeordnet. Der in dem Verdampfergehäuse 4 erzeugte Dampf strömt deshalb bei dieser Ausführungsform über einen Durchlass 23 axial in den Düsenkörper 1. Der Düsenkörper 1 ist vergleichbar mit dem nach Figur 1 gestaltet. Er hat wiederum die in Figur 1 gezeigte Trennwand 11, so dass der Dampf zunächst in die ebenfalls nur in Figur 1 dargestellte Einlasskammer 12 und von dort in die Auslasskammer 13 zum Düsenspalt 2 gelangt. Nahe beider Stirnseiten des Verdampfergehäuses 4 greifen jeweils zwei Flanschplatten 24, 25; 26, 27 teilweise über das Verdampfergehäuse 4. Zwischen den Flanschplattenpaaren 24, 25; 26, 27 an den Stirnseiten des Verdampfergehäuses 4 sind gewendelte Heizdrähte 28 gespannt, so dass elektrische Energie von den Flanschplatten 24, 25 durch die Heizdrähte 28 zu den Flanschplatten 26, 27 zu fließen vermag.

Die Figur 4 lässt erkennen, dass das Verdampfergehäuse 4 von einem koaxialen Blechmantel 29 umschlossen ist. In dem Ringraum zwischen dem Blechmantel 29 und dem Verdampfergehäuse 4 sind in radialer Ausrichtung Isolierkörper 30 angeordnet. Bei dieser Ausführungsform hat jeder Isolierkörper 30 zwei zum Verdampfergehäuse 4 hin offene Aufnahmen 31, 32, welche den jeweiligen, gewendelt ausgeführten Heizdraht 28 aufnehmen.

Zu erkennen ist in Figur 4 auch der sektorförmige Durchlass 23, über den der im Verdampfergehäuse 4 erzeugte Dampf in den in Figur 3 gezeigten Düsenkörper 1 gelangt. Eine als Drehschieber ausgebildete Absperrvorrichtung 33, bei der es sich um ein segmentförmiges Teil handelt, vermag vor den Durchlass 23 geschwenkt zu werden und dadurch die Verbindung vom Verdampfergehäuse 4 zu dem Düsenkörper 1 zu unterbrechen.

Die Zuführung des Drahtes 6 kann bei dieser Ausführungsform ähnlich wie gemäß den Figuren 1 und 2 über ein Zuführrohr 5 erfolgen, welches jetzt jedoch an der vorderen Stirnwand des Verdampfergehäuses 4 angeordnet ist.

### Bezugszeichenliste

- 1: Düsenkörper
- 2: Düsenspalt
- 3: Verdampfer
- 4: Verdampfergehäuse
- 5: Zuführrohr

- 6: Draht
- 7: Stahlrohr
- 8: Heizstab
- 9: Stromanschluss
- 10: Stromanschluss

- 11: Trennwand
- 12: Einlasskammer
- 13: Auslasskammer
- 14: Dampfdurchlass
- 15: Verdampferkammer

- 16: Chargierkammer
- 17: Flüssigkeitsverbindung
- 18: Flüssigkeitsspiegel
- 19: Metallbad
- 20: Verschluss

- 21: Scharnier
- 22: Inertgasanschluss
- 23: Durchlass
- 24: Flanschplatte
- 25: Flanschplatte

- 26: Flanschplatte
- 27: Flanschplatte
- 28: Heizdraht
- 29: Blechmantel
- 30: Isolierkörper

- 31: Aufnahme
- 32: Aufnahme
- 33: Absperrvorrichtung
- 34: Anschluss
- 35: Anschluss

## Patentansprüche

1. Bedampfungsvorrichtung für Vakuum-Bedampfungsanlagen, welche einen mit einem elektrischen Heizer beheizten Verdampfer (3) mit einem Tiegel zum Verdampfen von zugeführtem Metall und einen Düsenkörper (1) mit einem Düsenspalt (2) zum Austritt des erzeugten Metalldampfes aufweist, wobei der Düsenkörper (1) als Hohlkörper ausgebildet ist und der Verdampfer (3) ein an diesen Düsenkörper (1) angeschlossenes, den Tiegel bildendes Verdampfergehäuse (4) hat, **dadurch gekennzeichnet, dass** der Verdampfer (3) mit seinem Verdampfergehäuse (4) mit einem Teilbereich der Mantelfläche des Düsenkörpers (1) verbunden ist, dass der Düsenkörper (1) durch eine Trennwand (11) in eine den Düsenspalt (2) aufweisende Auslasskammer (13) und eine mit dem Verdampfer (3) verbundene Einlasskammer (12) unterteilt ist und dass die Trennwand (11) mehrere, mit zunehmendem Abstand von dem Verdampfergehäuse (4) im Querschnitt zunehmende Dampfdurchlässe (14) aufweist.

2. Bedampfungsvorrichtung nach Anspruch 1, **dadurch gekennzeichnet, dass** die Dampfdurchlässe (14) an der unteren Seite der Trennwand (11) in Form von zur Unterseite hin offenen Ausnehmungen vorgesehen sind und dass der Querschnitt dieser Dampfdurchlässe (14) durch eine unterschiedliche Höhe der Dampfdurchlässe (14) unterschiedlich ist.

3. Bedampfungsvorrichtung nach zumindest einem der vorangehenden Ansprüche, **dadurch gekennzeichnet, dass** der Düsenkörper (1) als liegend angeordneter Zylinder ausgebildet ist.

4. Bedampfungsvorrichtung nach zumindest einem der vorangehenden Ansprüche, **dadurch gekennzeichnet, dass** das Verdampfergehäuse (4) in eine Chargierkammer (16) und eine Verdampferkammer (15) unterteilt ist und die Chargierkammer (16) und die Verdampferkammer (15) unterhalb des Flüssigkeitsspiegels (18) des geschmolzenen Metallbades (19) eine Flüssigkeitsverbindung (17) haben.

5. Bedampfungsvorrichtung nach zumindest einem der vorangehenden Ansprüche, **dadurch gekennzeichnet, dass** das Verdampfergehäuse (4) einen als Stahlrohr (7) ausgebildeten Boden hat und dass durch dieses Stahlrohr (7) mit Abstand zu seiner Innenwandung ein Heizstab (8) aus elektrisch leitender Keramik führt.

6. Bedampfungsvorrichtung nach Anspruch 5, **dadurch gekennzeichnet, dass** das Stahlrohr (7) rechteckigen Querschnitt hat und der Heizstab (8) ein übliches Verdampferschiffchen ist.

7. Bedampfungsvorrichtung nach zumindest einem der vorangehenden Ansprüche, **dadurch gekennzeichnet, dass** zum Zuführen des zu verdampfenden Metalles in Form von Draht (6) im Verdampfergehäuse (4) ein Zuführrohr (5) angeordnet ist und dass das Zuführrohr (5) einen bei nicht eingeführtem, drahtförmigem Metall das Innere des Verdampfergehäuses (4) nach außen abdichtenden Verschluss (20) hat.

8. Bedampfungsvorrichtung nach Anspruch 7, **dadurch gekennzeichnet, dass** der Verschluss (20) eine zum Inneren des Verdampfergehäuses (4) hin öffnende Klappe ist.

9. Bedampfungsvorrichtung nach zumindest einem der vorangehenden Ansprüche, **dadurch gekennzeichnet, dass** in die Verbindung zwischen dem Verdampfer (3) und dem Düsenkörper (1) eine Absperrvorrichtung (33) angeordnet ist.

10. Bedampfungsvorrichtung nach zumindest einem der vorangehenden Ansprüche, **dadurch gekennzeichnet, dass** der Verdampfer einen Inertgasanschluss (22) hat.

11. Bedampfungsvorrichtung nach zumindest einem der vorangehenden Ansprüche, **dadurch gekennzeichnet, dass** das Verdampfergehäuse (4) an einer Stirnseite des Düsenkörpers (1) angeschlossen ist.

12. Bedampfungsvorrichtung nach Anspruch 11, **dadurch gekennzeichnet, dass** das Verdampfergehäuse (4) an demjenigen Bereich der Stirnwand des Düsenkörpers (1) angeschlossen ist, welcher durch die Trennwand (11) die Einlasskammer (12) bildet.

13. Bedampfungsvorrichtung nach den Ansprüchen 11 oder 12, **dadurch gekennzeichnet, dass** das Verdampfergehäuse (4) zylindrisch und der Düsenkörper (1) außermittig an der oberen Seite einer Stirnwand des Verdampfergehäuses (4) angeschlossen ist.

14. Bedampfungsvorrichtung nach zumindest einem der Ansprüche 11 bis 13, **dadurch gekennzeichnet, dass** der Verschluss (20) zwischen dem Verdampfergehäuse (4) und dem Düsenkörper (1) durch einen Drehschieber im Anschluss des Düsenkörpers (1) am Verdampfergehäuse (4) gebildet ist.

15. Bedampfungsvorrichtung nach zumindest einem der Ansprüche 11 bis 14, **dadurch gekennzeichnet, dass** an beiden Stirnseiten des Verdampfergehäuses (4) zwei über das Verdampfergehäuse (4) greifende Flanschplatten (24, 25; 26, 27) als Stromzuführung angeordnet sind, wobei die Flanschplatten (26, 27) der einen Stirnseite mit der Masse und die anderen Flanschplatten (24, 25) mit einer Spannungsversorgung verbunden sind, und dass zwischen den Flanschplatten (24, 25; 26, 27) der beiden Stirnseiten Heizdrähte (28) außenseitig entlang des Verdampfergehäuses (4) geführt sind.

16. Bedampfungsvorrichtung nach Anspruch 15, **dadurch gekennzeichnet, dass** die Heizdrähte (28) von einem koaxial zu dem Verdampfergehäuse (4) angeordneten Blechmantel (29) umgeben sind.

17. Bedampfungsvorrichtung nach den Ansprüchen 15 oder 16, **dadurch gekennzeichnet, dass** die Heizdrähte (28) gewendelt ausgebildet und jeweils in einem zum Verdampfergehäuse (4) hin mit geringerem Querschnitt als es dem Durchmesser der Wendeln des Heizdrahtes (28) entspricht offenen Isolierkörper (30) angeordnet sind.

## Claims

1. A vapour-deposition device for vacuum coating plants, having an evaporator (3), which is heated by an electric heater and has a crucible for evaporating supplied metal, and a nozzle body (1) which has a nozzle gap (2) as the exit for the metal vapour generated, the nozzle body (1) being constructed as a hollow body and the evaporator (3) having an evaporator housing (4) which is connected to this nozzle body (1) and forms the crucible, **characterised in that** the evaporator (3) is connected to part of the lateral surface of the nozzle body (1) by its evaporator housing (4), **in that** the nozzle body (1) is sub-divided into an outlet chamber (13) having the nozzle gap (2) and an inlet chamber (12) connected to the evaporator (3) by a dividing wall (11), and **in that** the dividing wall has a plurality of vapour passages (14) increasing in cross-section as their spacing from the evaporator housing (4) increases.

2. A vapour-deposition device according to Claim 1, **characterised in that** the vapour passages (14) are provided on the underside of the dividing wall (11) in the form of cutouts which are open towards the underside, and **in that** the cross-section of these vapour passages (14) differs due to the different height of the vapour passages (14).

3. A vapour-deposition device according to at least one of the preceding claims, **characterised in that** the nozzle body (1) is constructed as a horizontally arranged cylinder.

4. A vapour-deposition device according to at least one of the preceding claims, **characterised in that** the evaporator housing (4) is sub-divided into a charging chamber (16) and an evaporation chamber (15) and the charging chamber (16) and the evaporation chamber (15) have a liquid connection (17) below the liquid level (18) of the molten metal bath (19).

5. A vapour-deposition device according to at least one of the preceding claims, **characterised in that** the evaporator housing (4) has a base constructed as a steel tube (7) and **in that** a heating rod (8) of electrically conductive ceramics leads through this steel tube (7) at a spacing from its inside wall.

6. A vapour-deposition device according to Claim 5, **characterised in that** the steel tube (7) has a rectangular cross-section and the heating rod (8) is a conventional evaporation boat.

7. A vapour-deposition device according to at least one of the preceding claims, **characterised in that** a supply tube (5) is arranged in the evaporator housing (4) for the purpose of supplying the metal in wire form to be evaporated, and **in that** the supply tube (5) has a closure (20) which seals the inside of the evaporator housing (4) off from the outside when no wire-shaped metal is being introduced into the housing.

8. A vapour-deposition device according to Claim 7, **characterised in that** the closure (20) is a flap which opens towards the inside of the evaporator housing (4).

9. A vapour-deposition device according to at least one of the previous claims, **characterised in that** a blocking device (33) is arranged in the connection between the evaporator (3) and the nozzle body (1).

10. A vapour-deposition device according to at least one of the preceding claims, **characterised in that** the evaporator has an inert-gas connection (22).

11. A vapour-deposition device according to at least one of the preceding claims, **characterised in that** the evaporator housing (4) is connected to an end face of the nozzle body (1).

12. A vapour-deposition device according to Claim 11, **characterised in that** the evaporator housing (4) is connected to that region of the end wall of the nozzle body (1) which forms the inlet chamber (12) as a result of the dividing wall (11).

13. A vapour-deposition device according to Claim 11 or 12, **characterised in that** the evaporator housing (4) is cylindrical and the nozzle body (1) is connected eccentrically to the upper side of an end wall of the evaporator housing (4).

14. A vapour-deposition device according to at least one of Claims 11 to 13, **characterised in that** the closure (20) between the evaporator housing (4) and the nozzle body (1) is formed by a rotary slide valve in the connection between the nozzle body (1) and the evaporator housing (4).

15. A vapour-deposition device according to at least one of Claims 11 to 14, **characterised in that** two flange plates (24, 25; 26, 27), which reach beyond the evaporator housing and act as a power supply, are arranged at the two end faces of the evaporator housing (4), the flange plates (26, 27) of the one end face being connected to earth and the other flange plates (24, 25) being connected to a voltage supply, and **in that** heating wires (28) are guided along the outside of the evaporator housing (4) between the flange plates (24, 25; 26, 27).

16. A vapour-deposition device according to Claim 15, **characterised in that** the heating wires (28) are surrounded by a metal enclosure (29) arranged coaxially to the evaporator housing (4).

17. A vapour-deposition device according to one of Claims 15 or 16, **characterised in that** the heating wires (28) are of a coiled construction and are each arranged in an insulating body (30) which opens towards the evaporator housing (4) with a cross-section smaller than the diameter of the coils of the heating wire (28).

## Revendications

1. Dispositif d'évaporation pour des installations de métallisation sous vide, comprenant un évaporateur (3) chauffé par un dispositif de chauffage électrique, avec un creuset pour vaporiser le métal amené et un corps de buse (1) avec une fente de buse (2) pour la sortie de la vapeur de métal générée, le corps de buse (1) étant réalisé comme corps creux et l'évaporateur (3) étant muni d'un boîtier d'évaporateur (4) relié à ce corps de buse (1) et formant le creuset, **caractérisé en ce que** :
- l'évaporateur (3) est relié par son boîtier d'évaporateur (4) à une zone partielle de la surface enveloppe du corps de buse (1) ;
- le corps de buse (1) est divisé par une paroi de séparation (11) en une chambre d'échappement (13) comprenant la fente de buse (2) et en une chambre d'admission (12) reliée à l'évaporateur (3) ; et
- la paroi de séparation (11) comprend plusieurs passages de vapeur (14) dont la section transversale augmente avec l'augmentation de la distance depuis le boîtier d'évaporateur (4).

2. Dispositif d'évaporation selon la revendication 1, **caractérisé en ce que** les passages de vapeur (14) sont prévus sur la face inférieure de la paroi de séparation (11) sous la forme d'évidements ouverts vers la face inférieure, et **en ce que** la section transversale de ces passages de vapeur (14) diffère à des hauteurs différentes des passages de vapeur (14).

3. Dispositif d'évaporation selon l'une ou l'autre des revendications 1 et 2, **caractérisé en ce que** le corps de buse (1) est réalisé comme cylindre agencé couché.

4. Dispositif d'évaporation selon l'une au moins des revendications précédentes, **caractérisé en ce que** le boîtier d'évaporateur (4) est subdivisé en une chambre de chargement (16) et en une chambre d'évaporateur (15), et **en ce que** la chambre de chargement (16) et la chambre d'évaporateur (15) présentent une liaison vis-à-vis du liquide (17) en dessous du niveau (18) du bain de métal en fusion (19).

5. Dispositif d'évaporation selon l'une au moins des revendications précédentes, **caractérisé en ce que** le boîtier d'évaporateur (4) possède un fond réalisé comme tube d'acier (7) et **en ce qu'**une barre chauffante (8) électroconductrice en céramique passe dans ce tube d'acier (7), à distance de sa paroi intérieure.

6. Dispositif d'évaporation selon la revendication 5, **caractérisé en ce que** le tube d'acier (7) a une section transversale rectangulaire et que la barre chauffante (8) est une coupelle d'évaporateur usuelle.

7. Dispositif d'évaporation selon l'une au moins des revendications précédentes, **caractérisé en ce qu'**un tube d'amenée (5) est agencé dans le boîtier d'évaporateur (4) pour amener le métal à évaporer sous la forme d'un fil (6), et **en ce que** le tube d'amenée (5) possède une fermeture (20) qui étanche l'intérieur du boîtier d'évaporateur (4) vers l'extérieur lorsque le métal en forme de fil n'est pas introduit.

8. Dispositif d'évaporation selon la revendication 7, **caractérisé en ce que** la fermeture (20) est un volet qui s'ouvre vers l'intérieur du boîtier d'évaporateur (4).

9. Dispositif d'évaporation selon l'une au moins des revendications précédentes, **caractérisé en ce qu'**un dispositif d'arrêt (33) est agencé dans la liaison entre l'évaporateur (3) et le corps de buse (1).

10. Dispositif d'évaporation selon l'une au moins des revendications précédentes, **caractérisé en ce que** l'évaporateur est muni d'un raccordement de gaz inerte (22).

11. Dispositif d'évaporation selon l'une au moins des revendications précédentes, **caractérisé en ce que** le boîtier d'évaporateur (4) est raccordé à une face frontale du corps de buse (1).

12. Dispositif d'évaporation selon la revendication 11, **caractérisé en ce que** le boîtier d'évaporateur (4) est raccordé à cette zone de la paroi frontale du corps de buse (1), qui forme la chambre d'admission (12) par la paroi de séparation (11).

13. Dispositif d'évaporation selon l'une ou l'autre des revendications 11 et 12, **caractérisé en ce que** le boîtier d'évaporateur (4) est cylindrique et **en ce que** le corps de buse (1) est raccordé de manière décentrée à la face supérieure d'une paroi frontale du boîtier d'évaporateur (4).

14. Dispositif d'évaporation selon l'une au moins des revendications 11 à 13, **caractérisé en ce que** la fermeture (20) entre le boîtier d'évaporateur (4) et le corps de buse (1) est réalisée par un tiroir rotatif dans le raccordement du corps de buse (1) sur le boîtier d'évaporateur (4).

15. Dispositif d'évaporation selon l'une au moins des revendications 11 à 14, **caractérisé en ce que**, sur les deux faces frontales du boîtier d'évaporateur (4), deux plaques à bride (24, 25, 26, 27) s'engageant par le boîtier d'évaporateur (4) sont agencées pour l'alimentation électrique, les plaques à bride (26, 27) d'une de ces faces frontales étant reliées à la masse et les autres plaques à bride (24, 25) étant reliées à une tension d'alimentation, et **en ce qu'**entre les plaques à bride (24, 25, 26, 27) des deux faces frontales, des fils de chauffage (28) sont posés sur l'extérieur, le long du boîtier d'évaporateur (4).

16. Dispositif d'évaporation selon la revendication 15, **caractérisé en ce que** les fils de chauffage (28) sont entourés d'une gaine en tôle (29) agencée coaxialement au boîtier d'évaporateur (4).

17. Dispositif d'évaporation selon l'une ou l'autre des revendications 15 ou 16, **caractérisé en ce que** les fils de chauffage (28) sont réalisés en spirale et agencés respectivement dans un corps isolant ouvert (30) jusque vers le boîtier d'évaporateur (4), avec une section transversale plus petite que le diamètre de spire du fil de chauffage (28).
